Europäisches Patentamt

European Patent Office

Office européen des brevets

(11) Publication number: **0 092 176**
**B1**

# (12) EUROPEAN PATENT SPECIFICATION

(45) Date of publication of patent specification: **03.08.88**

(21) Application number: **83103612.4**

(22) Date of filing: **14.04.83**

(51) Int. Cl.⁴: **H 01 L 27/02**

(54) **Basic cell for integrated-circuit gate arrays.**

(30) Priority: **15.04.82 IT 6750182**

(43) Date of publication of application:
**26.10.83 Bulletin 83/43**

(45) Publication of the grant of the patent:
**03.08.88 Bulletin 88/31**

(84) Designated Contracting States:
**AT BE CH DE FR GB LI NL SE**

(56) References cited:
**ELECTRONIC ENGINEERING, vol. 54, no. 663,
March 1982, pages 53-57, London, GB;
"Designing with ULA's. Part 1 technology and
circuit elements"**

**IEEE CIRCUITS AND SYSTEMS MAGAZINE,
vol. 3, no. 3, September 1981, pages 14-18,
New York, US; R. NOTO et al.: "Automated
universal array"**

(73) Proprietor: **CSELT Centro Studi e Laboratori
Telecomunicazioni S.p.A.
Via Guglielmo Reiss Romoli, 274
I-10148 Turin (IT)**

(72) Inventor: **Gandini, Marco
C.so Siracusa, 118
Torino (IT)**
Inventor: **Trevisan, Dante
Via Saluzzo, 69
Torino (IT)**

(74) Representative: **Riederer Freiherr von Paar zu
Schönau, Anton et al
Van der Werth, Lederer & Riederer Freyung 615
Postfach 2664
D-8300 Landshut (DE)**

Courier Press, Leamington Spa, England.

## Description

The present invention relates to logic-gate arrays manufactured as integrated circuit and more particularly it concerns a basic cell of said arrays.

When producing integrated-circuit gate arrays, the main goals to be reached are to minimize design and embodiment costs, the space occupied by the circuit (or to obtain the maximum gate density in a given space) and the power consumption; these goals are to be reached with highly reliable circuits.

In the technique cost minimization is obtained as a rule by limiting the specialization only to the last metallization level: that means that all the production steps, but the last one, are always the same regardless of the logic functions the circuit is to carry out, while the last step serves just to differentiate such functions. When applying such technology, the circuits are obtained as a combination of a plurality of identical basic cells, which have been duly interconnected in the last phase. A cell must then have minimum surface and be easily connectable with the other cells and, besides, it ought to be suited to the implementation of logic arrays capable also of carrying out complex functions, in particular dynamic logic arrays (i.e. arrays using capacitive elements as memory elements).

For instance in the paper entitled "CAD pits semicustom chips against standard slices" by J. H. Kroeger and O. N. Tozun, Electronics, 3rd July 1980, a cell is described which comprises 6 transistors and a polysilicon pass over the two metal power lines. This cell presents a number of disadvantages: six transistors render the surface relatively wide and are an excess for the execution of simple functions, feasible with just two or four transistors; the cell input-output contacts are too many for simple functions; it is impossible to connect transistor gates inside the cell and to carry out dynamic functions.

Oversize problems due to the presence of six transistors per cell are eliminated in commercially-available logic arrays based on a cell with only four transistors. Yet said cell does not allow the implementation of dynamic functions and has no contacts inside the cell in correspondence with the transistor gates, so that the cell size is not the smallest possible; furthermore the cell does not present the polysilicon pass, and hence it is not possible to connect elements placed at opposite sides with respect to the metal power lines.

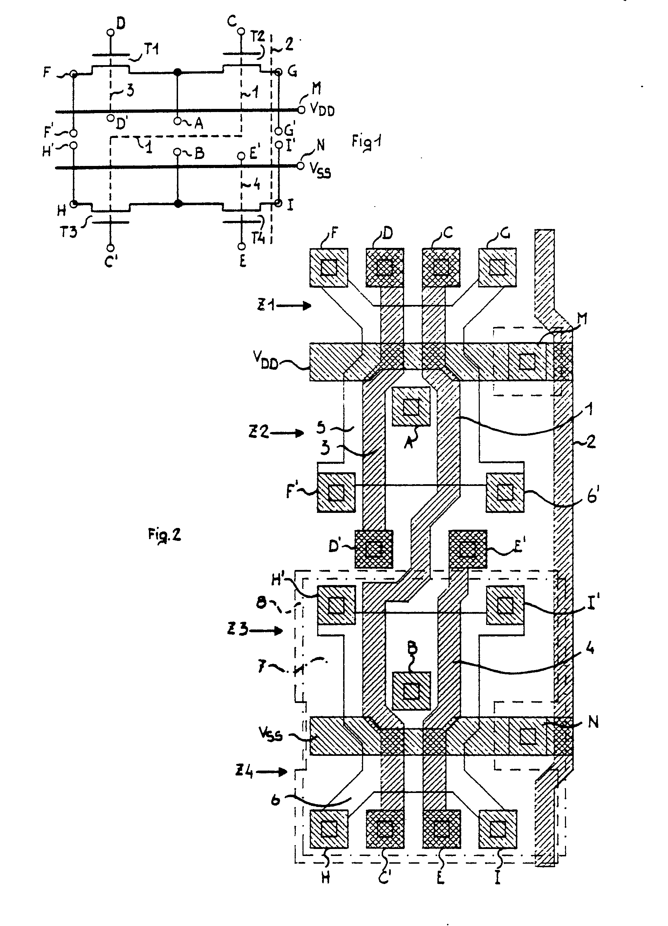

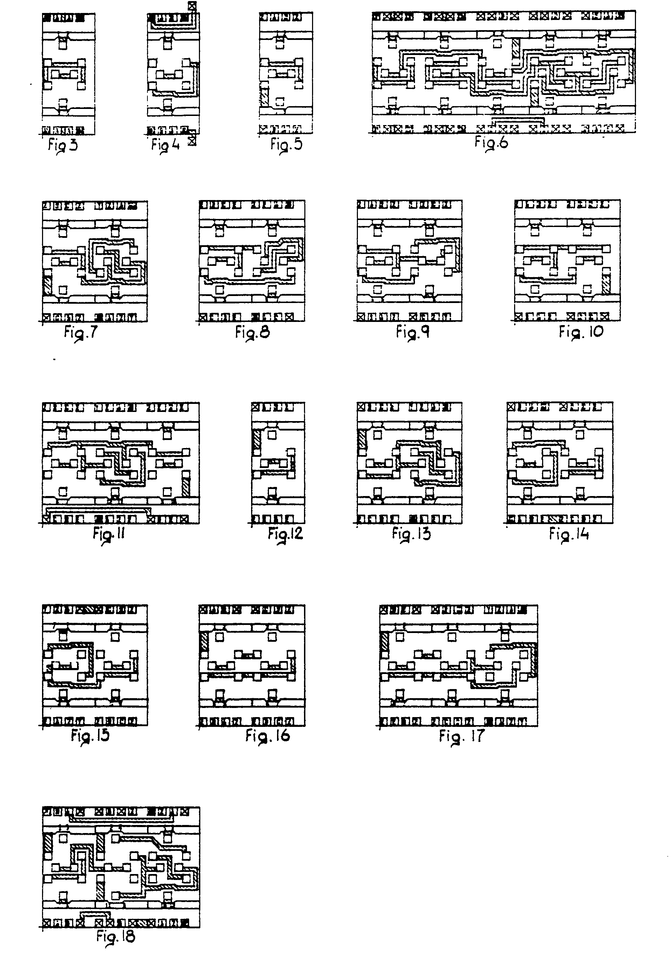

Another basic cell described and shown in the paper entitled "Designing with ULA's. Part 1 technology and circuit elements" in Electronic Engineering, Vol. 54, No. 663, March 1982, pages 53—57, Figure 5, uses ten transistors subdivided into a small subdivision of four transistors and a larger subdivision of six transistors. The small division shows the features of the prior art portion of claim 1 but uses five input-output contacts arranged in two rows outside the zone defined by the metal power lines and thus is not optimal with reference to surface minimization. The larger subdivision is provided with a pass connecting the two sides of the cell with one of the internal transistors of the cell.

The above problems are solved by the four transistor cell of the invention, where the contacts are arranged so as to minimize the cell surface and where it is possible to connect elements placed at opposite sides with respect to the metal power lines. The cell comprising these four transistors is according to the invention arranged as defined in claim 1.

The subject of claim 2 considerably contributes to the surface minimization as the contacts arranged in the single row outside the metal power lines are four contacts only.

The measure of claim 3, without considerably enlarging the surface of the basic cell, provides for the possibility of arranging specializing metal lines between the power lines and the proximal input-output contacts not only within the zone between the metal power lines as in the prior art (Electronic Engineering) but also outside of this zone. This allows interconnection of different cells without the need of elements external to the cell, thereby increasing flexibility and assisting in reducing the array surface of a given number of cells.

For a better understanding reference is made to the annexed drawings in which:

— Fig. 1 is a symbolic circuit diagram of the cell according to the invention;

— Fig. 2 shows the layout of the cell of Fig. 1;

— Figs. 3 to 49 are examples of logic arrays which can be implemented by using the invention.

In Figure 1 the cell according to the invention comprises 4 FETs T1, T2, T3, T4, the first two of P-type and the others of N-type, made so that the transistors of the same type have the source or the drain in common. By way of example hereinafter the drain will be supposed to be the common electrode, the contact of which is denoted by A for transistors T1, T2 and by B for transistors T3, T4. References F, G, H, I denote the contacts of the sources of the four transistors. The gates of a P transistor and of an N-transistor symmetrical with respect to a central cell point (e.g. transistors T2, T3) are connected by a polysilicon pass 1 (denoted by dotted lines) which crosses the two metal power lines $V_{SS}$, $V_{DD}$ (denoted by solid lines).

The contacts corresponding to such gates are denoted by C, C'. References D, E denote the contacts of the gates of T1 and T4 which on the contrary are independent.

A second polysilicon pass 2 crosses the two metal power lines allowing the connection of elements placed at opposite sides with respect to said lines. Further polysilicon passes 3, 4, connect contacts D, E of the gates of T1, T4 placed outside the zone defined by the metal power lines, to contacts D', E' placed inside such zone.

Finally, references M, N denote the power line contacts.

Figure 2, besides the elements already described with reference to Figure 1, shows the active areas 5, 6, wherefrom the sources and drains of the transistors are obtained, and masks 7 and 8 for the P-well and the N-diffusion necessary to make N-transistors.

In the Figure, it is to be noted that, outside the zone defined by the metal power lines, input-output contacts F, D, C, G, and H, C', E, I, are aligned and parallel to the metal power lines. This is one of the factors which reduce the cell size as the input-output areas are as small as possible.

Besides, contacts A, B of the drains of the two transistor pairs are located inside the zone defined by the metal power lines; in this way the size of the active area is reduced (and thus the cell size can be further reduced) and besides there are only four input-output points, i.e. the minimum necessary for the operations requiring a plurality of inputs or outputs. In addition input-output contacts and the contacts inside the zone defined by the metal power lines let four zones (denoted by Z1, Z2, Z3, Z4) free for further metallizations, and such number of zones is the minimum necessary to the execution of all the logic functions.

Lastly the "cross" pass 1 allows the implementation of capacitive memory elements.

Figures 3 to 49 show the specialization masks designed to obtain the wanted logic arrays either from the cell of Figures 1 or 2 or from the combination of a plurality of cells.

More particularly:

— an only cell allows the implementation of the functions of: fast inverter (Fig. 3), doubler inverter (Figure 4), two input NAND gate (Figure 5), two input NOR gate (Figure 12), tri-state output (Figure 32);

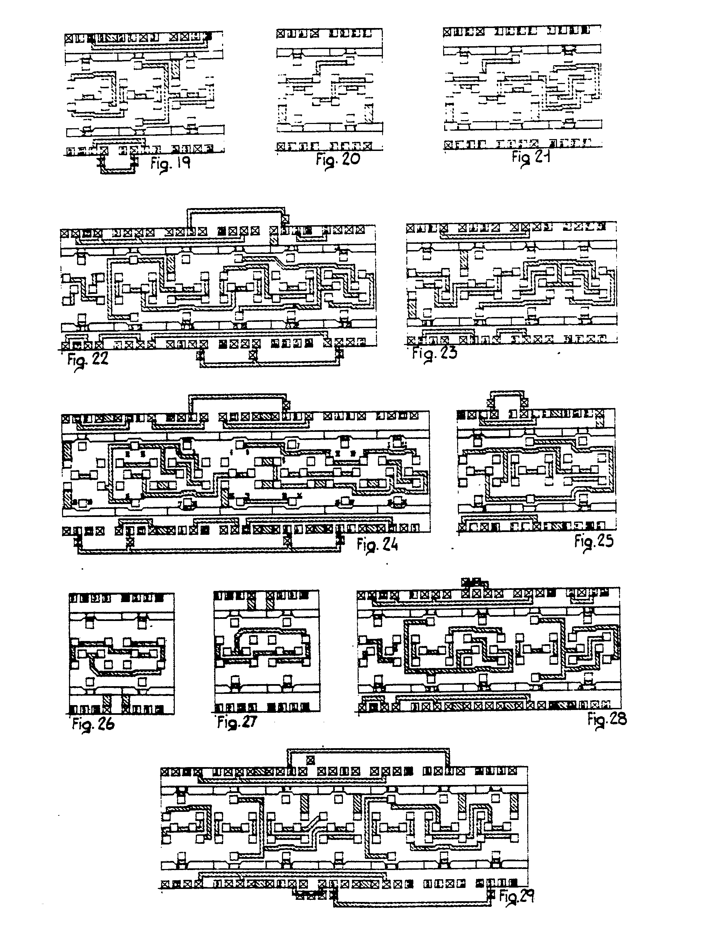

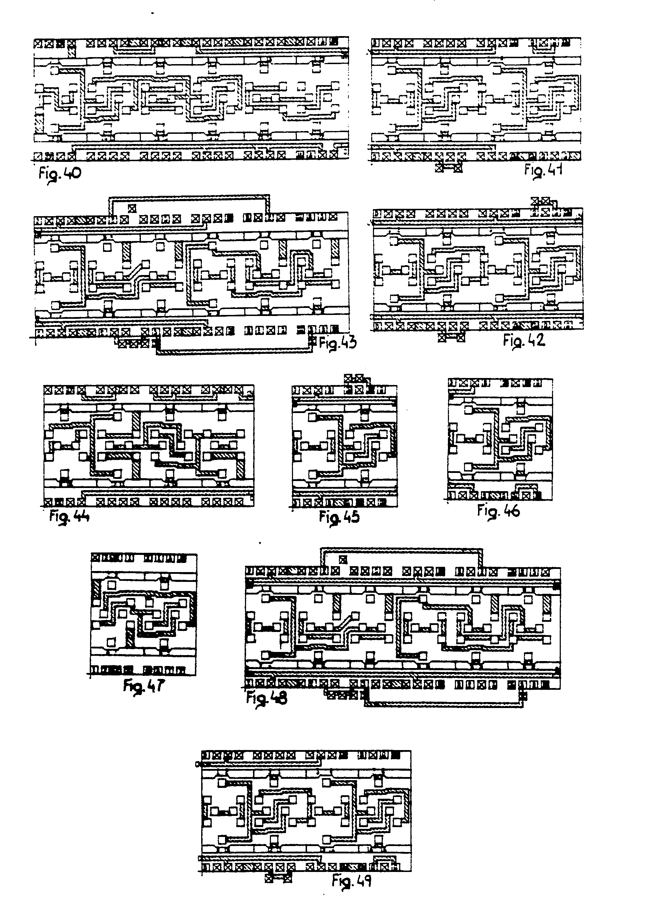

— two cells allow the implementation of the functions of: two input NAND/AND gate plus an inverter (Fig. 7), three-input NAND gate plus an inverter (Fig. 8), three-input NAND/AND gate (Fig. 9), four input NAND gate (Fig. 10), two-input NOR/OR gate plus an inverter (Fig. 13), three-input NOR gate plus an inverter (Fig. 14), three-input NOR/OR gate (Fig. 15), four-input NOR gate (Fig. 16), two AND gates plus a NOR gate (Fig. 20), two-input multiplexer (Fig. 34), set reset flip-flop made of NAND gates (Fig. 26) or NOR gates (Fig. 27), middle bit (Fig. 36) or end bit (Fig. 38) of a dynamic shift register, middle bit (Fig. 45), or end bit (Fig. 46) of a latch register, input trigger (Fig. 47);

— three cells allow the implementation of four input NAND/AND gate plus an inverter (Fig. 11), four input NOR/OR gate plus an inverter (Fig. 17), exclusive OR gate plus a NOR gate (Fig. 18), double AND-NOR gate plus an OR gate and an inverter (Fig. 21), D-latch (Fig. 31), D-latch with set (Fig. 19), or reset (Fig. 25);

— four cells allow the implementation of the functions of half-adder plus an inverter (Fig. 23), D-latch with set and reset (Fig. 30), dynamic register plus clock driver (Fig. 37), middle bit (Fig. 39), or end bit (Fig. 41), of a shift register, middle bit (Fig. 42), or end bit (Fig. 49) of a D-register clock driver (Fig. 44);

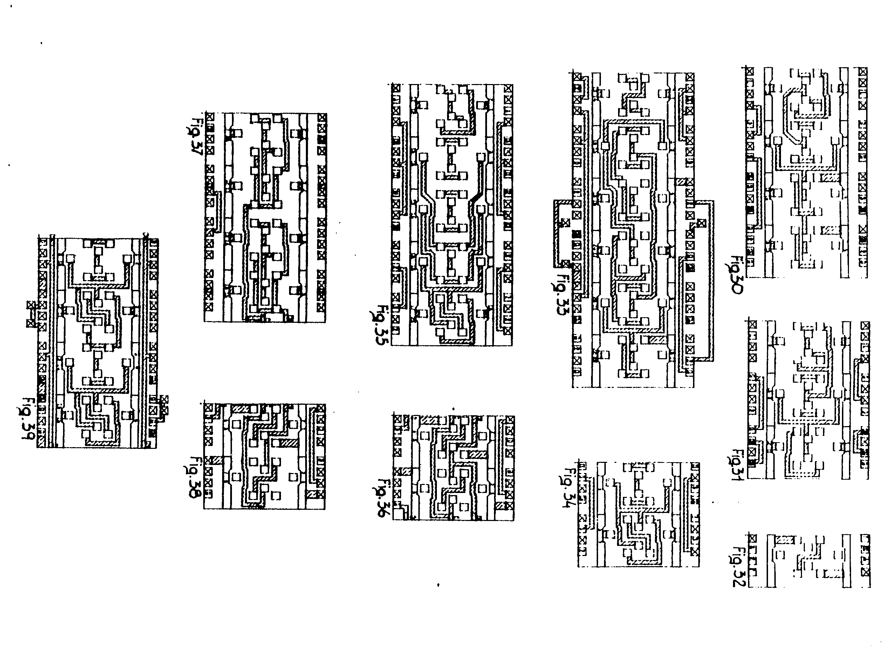

— five cells allow the implementation of the functions of four-input multiplexer (Fig. 35), D-type flip-flop (Fig. 28), driver with tri-state output (Fig. 6);

— six cells allow the implementation of the functions of D-type flip-flop with set (Fig. 22) or reset (Fig. 33), clock driver (Fig. 40), middle bit (Fig. 48) or end bit (Fig. 43) of a D-register with set and reset;

— seven cells allow the implementation of the functions of full-adder (Fig. 24), and of D-type flip-flop with set and reset (Fig. 29).

The supplementary metallizations shown in Figures 3—49 establish the conventional connections necessary to obtain the specified functions and therefore they do not require a detailed description; crosses denote non-usable contacts.

The term "polysilicon" denotes polycristalline silicon, i.e. silicon which is not in single-crystal form as the substrate.

When creating the diffusion zones, also this silicon is doped so as to become conductive and to allow connection between different parts of the circuit: in particular, the polysilicon passes of Figs. 1 and 2 denote two such connections which allow the metallizations $V_{DD}$, $V_{SS}$ to be crossed, in order to connect points located on opposite sides thereof.

## Claims

1. A basic cell for integrated circuit gate arrays, comprising a semiconductor substrate traversed by two parallel metal power lines ($V_{SS}$, $V_{DD}$) which define a zone therebetween, and containing two field effect transistors of P-type (T1, T2) and two field effect transistors of N-type (T3, T4) each comprising a channel (5, 6), two electrodes arranged at two ends of the channel and connected to contacts (A, F, G; B, H, I), and a gate also connected to a contact (D, C, C', E), the transistors being implemented so that the transistors of a same type have in common the electrode placed at one end of the channel, the gates (C, C') of one (T2) of the transistors of P-type and one (T3) of the transistors of N-type, these selected transistors being placed symmetrically with respect to a central point of the cell, being connected by a first polysilicon pass (1) crossing both of the metal power lines, characterized in that of these four transistors (T1, T2, T3, T4) constituting all of the active components of the basic cell, the contacts (C, D; C', E) of the gates of two transistors of a same type (T1, T2; T3, T4) and the contacts (F, G; H, I) of the non-common electrodes of these transistors are aligned and arranged in parallel to the metal power lines ($V_{SS}$, $V_{DD}$) outside the zone defined by such lines to form sets of input/output contacts of the cell, and that the metal power lines are crossed by a second polysilicon pass (2) joining areas placed at the opposite sides of the zone defined by the metal power lines.

2. Basic cell according to claim 1, wherein the contacts (F, G; H, I) of the non-common electrodes and the contacts (C, D; C', E) of the gates other than the interconnected gates are moreover associated with corresponding contacts (F', D', G'; H', E', I') placed inside the zone defined by the metal power lines ($V_{SS}$, $V_{DD}$), characterized in that the contacts (A, B) of the electrodes each common to the transistors of equal type (T1, T2; T3, T4) are arranged adjacent with the proximal metal power line inside the zone defined by the metal power lines, leaving four contacts of each pair of transistors to be arranged outside said zone.

3. Basic cell according to claim 1 or 2, characterized in that all of the contacts (F, D, G, H, E, I, F', D', G', H', E', I') apart from the ones of the electrodes each common to the transistors of equal type have distances to the respective proximal metal power line ($V_{SS}$, $V_{DD}$) so as to leave a free space for the passage of a single specializing metallization.

**Patentansprüche**

1. Basiszelle für integrierte Verknüpfungsschaltungsfelder, mit einem Halbleitersubstrat, das durch zwei parallele metallene Stromleiter ($V_{SS}$, $V_{DD}$) überquert wird, welche eine dazwischenliegende Zone begrenzen, und mit zwei Feldeffekttransistoren des p-Typs (T1, T2) und zwei Feldeffekttransistoren des n-Typs (T3, T4), die jeweils einen Kanal (5, 6), zwei an den beiden Enden des Kanals angeordnete und mit Anschlüssen (A, F, G; B, H, I) verbundene Elektroden und ein ebenfalls mit einem Anschluß (D, C, C', E) verbundenes Tor umfassen und so angelegt sind, daß die Transistoren gleichen Typs die an einem Ende des Kanals befindliche Elektrode gemeinsam haben und die Tore (C, C') eines (T2) der Transistoren des p-Typs und eines (T3) der Transistoren des n-Typs, wobei diese ausgewählten Transistoren symmetrisch im Bezug zu einem zentralen Punkt der Zelle angeordnet sind, über einen ersten Polysiliciumpaß (1) verbunden sind, der die beiden metallenen Stromleiter kreuzt, dadurch gekennzeichnet, daß von diesen vier Transistoren (T1, T2, T3, T4), die sämtliche aktiven Komponenten der Basiszelle bilden, die Anschlüsse (C, D; C', E) der Tore von zweien der Transistoren gleichen Typs (T1, T2; T3, T4) und die Anschlüsse (F, G; H, I) der nicht-gemeinsamen Elektroden dieser Transistoren aufeinander ausgerichtet und parallel zu den metallenen Stromleitern ($V_{SS}$, $V_{DD}$) außerhalb der durch diese Leiter begrenzten Zone als Gruppen von Eingangs/Ausgangs-Anschlüssen der Zelle angeordnet sind und daß die metallenen Stromleiter von einem zweiten Polysiliciumpaß (2) gekreuzt werden, der an gegenüberliegenden Seiten der von den metallenen Stromleitern begrenzten Zone liegenden Flächen miteinander verbindet.

2. Basiszelle nach Anspruch 1, bei der die Anschlüsse (F, G; H, I) der nicht-gemeinsamen Elektroden und die Anschlüsse (C, D; C', E) der Tore, die nicht miteinander verbunden sind, darüberhinaus mit entsprechenden Anschlüssen (F', D', G'; H', E', I') verbunden sind, die innerhalb der durch die metallenen Stromleiter ($V_{SS}$, $V_{DD}$) begrenzten Zone liegen, dadurch gekennzeichnet, daß die Anschlüsse (A, B) der Elektroden, die jeweils den Transistoren gleichen Typs (T1, T2; T3, T4) gemeinsam sind, in der Nachbarschaft des näheren metallenen Stromleiters innerhalb der von den metallenen Stromleitern begrenzten Zone angeordnet sind, wobei für jedes Transistorenpaar vier Anschlüsse in einer Anordnung außerhalb dieser Zone verbleiben.

3. Basiszelle nach Anspruch 1 oder 2, dadurch gekennzeichnet, daß alle Anschlüsse (F, D, G, H, E, I, F', D', G', H', E', I') außer denjenigen der den Transistoren gleichen Typs gemeinsamen Elektroden Abstände vom jeweiligen näherliegenden metallischen Stromleiter ($V_{SS}$, $V_{DD}$) unter Freilassung eines freien Raums für den Hindurchverlauf einer einzelnen spezialisierenden Metallisierung haben.

**Revendications**

1. Cellule de base poure réseaux de portes à circuit intégré, comprenant un substrat de semiconducteur croisé par deux métallisations parallèles d'alimentation ($V_{SS}$, $V_{DD}$), qui délimitent une zone entr'elles, et comprenant deux transistors à effet de champ de type P (T1, T2) et deux transistors à effet de champ de type N (T3, T4), chacun comprenant un canal, deux électrodes placées aux deux extrémités du canal et connectées à des contacts (A, F, G; B, H, I), et une grille elle aussi connectée à un contact (D, C, C', E), les transistors étant réalisés de façon que les transistors du même type aient en commun une des électrodes placées à l'extrémité du canal, les grilles (C, C') d'un des transistors P (T2) et d'un des transistors N (T3)—ces transistors choisis étant symétriques par rapport à un point central de la cellule—étant connectées par un premier passage de polysilicium (1) qui croise les deux métallisations d'alimentation, caractérisée en ce que, en ces quatre transistors (T1, T2, T3, T4), qui constituent tous les composants actifs de la cellule de base, les contacts (C, D; C', E) des grilles de deux transistors du même type (T1, T2; T3, T4) et les contacts (F, G; H, I) des électrodes non communes des mêmes transistors sont alignés et disposés parallèles aux métallisations d'alimentation ($V_{SS}$, $V_{DD}$), à l'extérieur de la zone délimitée par ces métallisations, pour former des groupes de contacts d'entrée-sortie de la cellule, et en ce que les métallisations d'alimentation sont également croisées par un second passage de polysilicium (2) qui joint des zones placées du côté opposé par rapport à la zone délimitée par les métallisations d'alimentation.

2. Cellule de base selon la revendication 1, où les contacts (F, G; H, I) des électrodes non communes et les contacts (C, D; C', E) des grilles non interconnectées sont en outre associés à des contacts correspondants (F', D', G', H', E', I') placés à l'intérieur de la zone délimitée par les métallisations d'alimentation, caractérisée en ce que le contact (A, B) de l'électrode commune aux transistors du même type (T1, T2, T3, T4) est disposé adjacent à la métallisation d'alimentation la plus proche à l'intérieur de la zone délimitée par les métallisations d'alimentation, en laissant quatre contacts de chaque paire de transistors à l'extérieur de cette zone.

3. Cellule de base selon l'une quelconque des revendications 1 ou 2, caractérisée en ce que tous les contacts (F, D, G, H, E, I; F', D', G', H', E', I') à l'exception de ceux des électrodes communes aux transistors du même type, sont à une distance de la métallisation d'alimentation la plus proche telle qu'elle laisse un espace libre pour une seule métallisation de spécialisation.

Fig 1

Fig. 2

0 092 176

Fig 3

Fig 4

Fig. 5

Fig. 6

Fig. 7

Fig. 8

Fig. 9

Fig. 10

Fig. 11

Fig. 12

Fig. 13

Fig. 14

Fig. 15

Fig. 16

Fig. 17

Fig. 18

2

0 092 176

Fig. 19

Fig. 20

Fig. 21

Fig. 22

Fig. 23

Fig. 24

Fig. 25

Fig. 26

Fig. 27

Fig. 28

Fig. 29

3

Fig.30

Fig.31

Fig.32

Fig. 33

Fig. 34

Fig.35

Fig.36

Fig.37

Fig. 38

Fig. 39

Fig. 40

Fig. 41

Fig. 43

Fig. 42

Fig. 44

Fig. 45

Fig. 46

Fig. 47

Fig. 48

Fig. 49